# EUROPEAN PATENT APPLICATION

(11) **EP 4 383 339 A1**
(43) Date of publication of application: **12.06.2024**
(21) Application number: 23760280.0
(22) Date of filing: 01.02.2023
(51) Int. Cl.: H01L 27/15, H01L 27/12, H01L 33/20, H01L 25/075, H01L 23/00, H01L 33/48

(54) **DISPLAY MODULE AND MANUFACTURING METHOD THEREFOR**

(30) Priority: 25.02.2022 KR 20220025433; 09.06.2022 KR 20220069915
(71) Applicant: Samsung Electronics Co., Ltd., Suwon-si, Gyeonggi-do 16677 (KR)
(72) Inventor: KIM, Myunghee, Suwon-si Gyeonggi-do 16677 (KR); SOHN, Sanghyun, Suwon-si Gyeonggi-do 16677 (KR)
(74) Representative: Appleyard Lees IP LLP
(86) International application number: PCT/KR2023/001457
(87) International publication number: WO 2023/163406

(57) **Abstract**

A display apparatus is provided. The display apparatus includes a plurality of thin film transistors (TFTs) provided on a substrate; and a plurality of pixels electrically connected to the plurality of TFTs. Each pixel includes a first light emitting diode, a second light emitting diode, and a third light emitting diode having different sizes from one another.

## Description

### [TECHNICAL FIELD]

The disclosure relates to a display module and a manufacturing method thereof.

Self-emission display elements may display an image without a color filter or backlight, and inorganic light emitting elements can be used as self-emission display elements.

A display module expresses various colors as it operates in pixel units or sub-pixel units consisting of, for example, inorganic light emitting elements under control of a plurality of thin film transistors (TFTs). The plurality of TFTs may be arranged on a flexible substrate, a glass substrate, or a plastic substrate, and a substrate including a plurality of TFTs as above may be referred to as a TFT substrate.

### [DISCLOSURE]

### [TECHNICAL SOLUTION]

The present disclosure provides a display module having a structure of high yield and high efficiency, and a manufacturing method thereof.

According to an embodiment, a display apparatus includes: a plurality of thin film transistors (TFTs) provided on a substrate; and a plurality of pixels electrically connected to the plurality of TFTs. Each pixel includes a first light emitting diode, a second light emitting diode, and a third light emitting diode having different sizes from one another.

The second light emitting diode may be bigger than the first light emitting diode, and the third light emitting diode may be bigger than the second light emitting diode.

The first light emitting diode may be configured to emit a light of a blue wavelength band, the second light emitting diode may be configured to emit a light of a green wavelength band, and the third light emitting diode may be configured to emit a light of a red wavelength band.

A light emitting surface of each of the first light emitting diode, the second light emitting diode, and the third light emitting diode may have a trapezoid shape.

Side surfaces of each of the first light emitting diode, the second light emitting diode, and the third light emitting diode may be inclined.

Each of the first light emitting diode, the second light emitting diode, and the third light emitting diode may have a cross-section that becomes gradually narrower as it approaches a surface opposite a light emitting surface.

Each of the first light emitting diode, the second light emitting diode, and the third light emitting diode may have a cross-section that becomes gradually wider as it approaches a surface opposite a light emitting surface.

According to an embodiment, a mold device for manufacturing a display apparatus, includes: a first mold including a plurality of first insertion grooves arranged in a first grid, wherein the plurality of first insertion grooves have a first size into configured to accommodate a plurality of first light emitting diodes; a second mold including a plurality of second insertion grooves arranged in a second grid, wherein the plurality of second insertion grooves have a second size bigger than the first size and are configured to accommodate a plurality of second light emitting diodes; and a third mold wherein a plurality of third insertion grooves having a third size bigger than the second size into which a plurality of third light emitting diodes are inserted are arranged in a grid form. In the second mold, a plurality of additional first insertion grooves corresponding to the first size are arranged in a grid form, and in the third mold, a plurality of additional second insertion grooves corresponding to the first size are arranged in a grid form, and a plurality of additional third insertion grooves corresponding to the second size are arranged in a grid form.

The plurality of additional first insertion grooves of the second mold may be arranged in locations corresponding to the plurality of first insertion grooves of the first mold, the plurality of additional second insertion grooves of the third mold may be arranged in locations corresponding to the plurality of first insertion grooves of the first mold, and the plurality of additional third insertion grooves of the third mold may be arranged in locations corresponding to the plurality of second insertion grooves of the second mold.

The first size may be bigger than the plurality of first light emitting diodes, the second size may be bigger than the plurality of second light emitting diodes, and the third size may be bigger than the plurality of third light emitting diodes.

The plurality of first insertion grooves, the plurality of second insertion grooves, the plurality of third insertion grooves, the plurality of additional first insertion grooves, the plurality of additional second insertion grooves, and the plurality of additional third insertion grooves may be trapezoid forms.

Side surfaces of each of the plurality of first insertion grooves, the plurality of second insertion grooves, and the plurality of third insertion grooves may be inclined.

A cross-section of each of the plurality of first insertion grooves, the plurality of second insertion grooves, and the plurality of third insertion grooves may become gradually narrower as it approaches a bottom side from an opening side.

According to an embodiment, a method of manufacturing a display apparatus includes: providing a plurality of first light emitting diodes in a first mold; providing a plurality of second light emitting diodes in a second mold; providing a plurality of third light emitting diodes in a third mold; transferring the plurality of first light emitting diodes, the plurality of second light emitting diodes, and the plurality of third light emitting diodes to a relay substrate respectively from the first mold, the second mold, and the third mold; and transferring the plurality of first light emitting diodes, the plurality of second light emitting diodes, and the plurality of third light emitting diodes to a thin film transistor (TFT) substrate from the relay substrate. The plurality of first light emitting diodes, the plurality of second light emitting diodes, and the plurality of third light emitting diodes are respectively inserted into a plurality of first insertion grooves of the first mold, a plurality of second insertion grooves of the second mold, and a plurality of third insertion grooves of the third mold by a fluidic self-assembly method.

The plurality of first light emitting diodes, the plurality of second light emitting diodes, and the plurality of third light emitting diodes may have different sizes from one another.

Each of the plurality of first insertion grooves may have a first size, each of the plurality of second insertion grooves may have a second size and each of the plurality of third insertion grooves may have a third size. The second size may be larger than the first size and smaller than the third size.

According to an embodiment, a method of manufacturing a display apparatus includes: providing a plurality of first light emitting diodes on a relay substrate in a first grid pattern; providing a mold including a plurality of first insertion grooves arranged in the first grid pattern and a plurality of second insertion grooves arranged in a second grid pattern; providing a plurality of second light emitting diodes in the plurality of second insertion grooves; providing the mold to the relay substrate so that the plurality of first light emitting diodes are accommodated in the plurality of first insertion grooves of the mold and the plurality of second light emitting diodes are adhered to the relay substrate; and removing the mold from the plurality of second light emitting diodes and the relay substrate.

The method may further include providing the relay substrate to a thin film transistor (TFT) substrate to adhere the plurality of first light emitting diodes and the plurality of second light emitting diodes to the TFT substrate.

Each of the plurality of first light emitting diodes may be smaller than each of the plurality of second light emitting diodes.

Each of the plurality of second light emitting diodes may be larger than each of the plurality of first insertion grooves.

### [DESCRIPTION OF DRAWINGS]

The above and other aspects, features, and advantages of certain embodiments of the present disclosure will be more apparent from the following detailed description, taken in conjunction with the accompanying drawings, in which:
FIG. 1 is a block diagram illustrating a display device according to an embodiment;
FIG. 2 is a plan view illustrating a display panel included in a display device according to an embodiment;
FIG. 3 is a diagram illustrating pixels in the III portion indicated in FIG. 2 according to an embodiment;
FIG. 4 is a diagram illustrating a cross-sectional view of a first light emitting diode mounted on a TFT substrate along the IV-IV line indicated in FIG. 3 according to an embodiment;
FIG. 5 is a flow chart illustrating a manufacturing method of a display device according to an embodiment;
FIG. 6 is a plan view illustrating a first mold according to an embodiment;
FIG. 7 is a cross-sectional view illustrating a first mold according to an embodiment;
FIG. 8 is a cross-sectional view illustrating first light emitting diodes inserted into insertion grooves of a first mold according to an embodiment;
FIG. 9 is a plan view illustrating a second mold according to an embodiment;
FIG. 10 is a cross-sectional view illustrating a second mold according to an embodiment;
FIG. 11 is a cross-sectional view illustrating second light emitting diodes inserted into insertion grooves of a second mold according to an embodiment;
FIG. 12 is a plan view illustrating a third mold according to an embodiment;
FIG. 13 is a cross-sectional view illustrating a third mold according to an embodiment;
FIG. 14 is a cross-sectional view illustrating third light emitting diodes inserted into insertion grooves of a third mold according to an embodiment;
FIG. 15 is a diagram illustrating a first mold aligned on a relay substrate according to an embodiment;
FIG. 16 is a diagram illustrating a first mold being made to adhere to a relay substrate for transferring a plurality of first light emitting diodes to the relay substrate from the first mold according to an embodiment;
FIG. 17 is a diagram illustrating a plurality of first light emitting diodes that have been transferred to a relay substrate from a first mold according to an embodiment;
FIG. 18 is a diagram illustrating a second mold aligned on a relay substrate according to an embodiment;
FIG. 19 is a diagram illustrating a second mold being made to adhere to a relay substrate for transferring a plurality of second light emitting diodes to the relay substrate from the second mold according to an embodiment;
FIG. 20 is a diagram illustrating a plurality of second light emitting diodes that have been transferred to a relay substrate from a second mold according to an embodiment;
FIG. 21 is a diagram illustrating a third mold aligned on a relay substrate according to an embodiment;
FIG. 22 is a diagram illustrating a third mold being made to adhere to a relay substrate for transferring a plurality of third light emitting diodes to the relay substrate from the third mold according to an embodiment;
FIG. 23 is a diagram illustrating a plurality of third light emitting diodes that have been transferred to a relay substrate from a third mold according to an embodiment;
FIG. 24 is a diagram illustrating a relay substrate aligned on a TFT substrate according to an embodiment;
FIG. 25 is a diagram illustrating a relay substrate being heat pressed to a TFT substrate according to an embodiment;
FIG. 26 is a diagram illustrating a plurality of first to third light emitting diodes that have been transferred to a TFT substrate from a relay substrate according to an embodiment;
FIG. 27 is a cross-sectional view illustrating a first light emitting diode mounted on a TFT substrate according to an embodiment;
FIG. 28 is a flow chart illustrating a manufacturing method of a display device according to an embodiment;
FIG. 29 is a cross-sectional view illustrating first light emitting diodes inserted into insertion grooves of a first mold according to an embodiment;
FIG. 30 is a diagram illustrating a first mold aligned on a TFT substrate according to an embodiment;
FIG. 31 is a diagram illustrating a first mold being heat pressed to a TFT substrate according to an embodiment;
FIG. 32 is a diagram illustrating a plurality of first light emitting diodes that have been transferred to a TFT substrate from a first mold according to an embodiment;
FIG. 33 is a diagram illustrating a second mold aligned on a TFT substrate according to an embodiment;
FIG. 34 is a diagram illustrating a second mold being heat pressed to a TFT substrate according to an embodiment; and
FIG. 35 is a diagram illustrating a plurality of third light emitting diodes that have been transferred to a TFT substrate from a third mold according to an embodiment.

### [MODE FOR INVENTION]

Hereinafter, embodiments will be described with reference to the accompanying drawings. Embodiments described in this specification may be modified in various forms. Specific embodiments may be illustrated in the drawings, and explained in detail in the detailed description. However, specific embodiments described herein and illustrated in the accompanying drawings are for making the various embodiments understood easily. Therefore, the technical idea of the disclosure is not limited by the specific embodiments described in the accompanying drawings, but they should be interpreted to include all equivalents or alternatives included in the ideas and the technical scopes of the disclosure.

Like reference numerals refer to like elements and a repeated description related thereto will be omitted. As used herein, the terms "1st" or "first" and "2nd" or "second" may use corresponding components regardless of importance or order and are used to distinguish a component from another component without limiting the components. Expressions such as "at least one of" when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. Those of ordinary skill in the art will recognize that modification, equivalent, and/or alternative on the various embodiments described herein may be variously made without departing from the scope and spirit of the disclosure.

In addition, in the disclosure, terms such as "include" or "have" should be construed as designating that there are such characteristics, numbers, steps, operations, elements, components or a combination thereof described in the specification, but not as excluding in advance the existence or possibility of adding one or more of other characteristics, numbers, steps, operations, elements, components or a combination thereof. Further, the description in the disclosure that an element is "coupled with/to" or "connected to" another element should be interpreted to mean that the one element may be directly coupled with/to or connected to the another element, but still another element may exist between the elements. In contrast, the description that one element is "directly coupled" or "directly connected" to another element can be interpreted to mean that still another element does not exist between the one element and the another element.

Also, in the disclosure, the expression 'identical' not only indicates that some features perfectly coincide, but also indicates that the features include a difference in consideration of a machining error range.

Other than the above, in describing the disclosure, in case it is determined that detailed explanation of related known functions or features may unnecessarily confuse the gist of the disclosure, the detailed explanation will be abridged or omitted.

In the disclosure, a display module may include a display panel including inorganic light emitting diodes for displaying images. Here, the display panel may be a flat display panel or a curved display panel, and a plurality of inorganic light emitting diodes (LEDs) of which sizes are 100 µm or smaller (e.g., micro LEDs or mini LEDs) may be mounted on the display panel, thereby providing better contrast, response time, and energy efficiency than an LCD which needs a backlight.

In the disclosure, `inorganic light emitting diodes' and `inorganic light emitting elements' may be used as the same meaning.

The inorganic light emitting elements applied to the disclosure have better brightness and light emitting efficiency, and a longer lifespan than organic light emitting diodes (OLEDs). The inorganic light emitting elements may be semiconductor chips that can emit a light by themselves in case power is supplied. Micro LEDs which are inorganic light emitting elements have faster response speed, low power consumption, and high luminance. For example, micro LEDs have higher efficiency in converting electricity into photons than a conventional LCD or OLEDs. That is, a display device which includes micro LEDs may have a higher "brightness per watt" than a conventional LCD or OLED display. Accordingly, micro LEDs can exert identical brightness with about half the energy compared to conventional LEDs (of which length, width, and height respectively exceed 100 µm) or OLEDs. Other than this, micro LEDs can implement high resolution, excellent colors, contrast, and brightness, and thus they can express colors in a wide range correctly, and can implement a clear screen in the outdoors where sunlight is bright. Also, micro LEDs are resistant against a burn-in phenomenon and generate little heat, and thus a long lifespan without distortion is guaranteed. Micro LEDs may have a flip chip structure wherein an anode electrode and a cathode electrode are formed on the same first surface, and a light emitting surface is formed on a second surface positioned on the opposite side of the first surface wherein the electrodes are formed.

In the disclosure, on the front surface of a substrate, a TFT layer wherein a thin film transistor (TFT) circuit is formed may be arranged, and on the rear surface, a power supply circuit supplying power to the TFT circuit, and a data driving driver, a gate driving driver, and a timing controller controlling each driving driver may be arranged. A plurality of pixels arranged on the TFT layer may be driven by the TFT circuit.

In the disclosure, the TFT provided to the display module may be a low-temperature polycrystalline silicon (LTPS) TFT, a low-temperature polycrystalline oxide (LTPO) TFT, or an oxide TFT.

In the disclosure, as a substrate, a glass substrate, a substrate based on a synthetic resin having a flexible material (e.g., polyimide (PI), polyethylene terephthalate (PET), polyethersulfone (PES), polyethylene naphthalate (PEN), polycarbonate (PC), etc.), or a ceramic substrate may be used.

In the disclosure, on the front surface of the substrate, a TFT layer on which a TFT circuit is formed may be arranged, and on the rear surface of the substrate, a circuit may not be arranged. The TFT layer may be formed integrally on the substrate, or manufactured in the form of a separate film, and attached on one surface of the glass substrate.

In the disclosure, the front surface of the substrate may be divided into an active area and an inactive area. The active area may be an area occupied by the TFT layer on the front surface of the substrate, and the inactive area may be an area excluding the area occupied by the TFT layer on the front surface of the substrate.

In the disclosure, an edge area of the substrate may be the outermost area of the glass substrate. Also, the edge area of the substrate may be the remaining area excluding the area wherein the circuit of the substrate is formed. In addition, the edge area of the substrate may include a part of the front surface of the substrate adjacent to the side surface of the substrate, and a part of the rear surface of the substrate adjacent to the side surface of the substrate. The substrate may be formed as a quadrangle type. For example, the substrate may be formed as a rectangle or a square. The edge area of the substrate may include at least one side among the four sides of the glass substrate.

In the disclosure, the TFT constituting the TFT layer (or the backplane) is not limited to a specific structure or type. For example, the TFT cited in the disclosure may be implemented as an oxide TFT, an Si TFT (poly silicon, a-silicon), an organic TFT, a graphene TFT, a low-temperature polycrystalline silicon (LTPS) TFT, and also, a P type (or an N-type) MOSFET may be formed in an Si wafer CMOS process and applied.

In the disclosure, the substrate included in the display module is not limited to a TFT substrate. For example, the display module may be a substrate wherein there is no TFT layer on which a TFT circuit is formed. In this case, the display module may include a substrate wherein only a wiring is patterned, and a micro IC is separately mounted.

In the disclosure, the pixel driving method of the display module may be an active matrix (AM) driving method or a passive matrix (PM) driving method. The display module may form the pattern of the wiring where each micro LED is electrically connected according to the AM driving method or the PM driving method.

In the disclosure, the display module may include a glass substrate on which a plurality of LEDs are mounted and a side surface wiring is formed. Such a display module may be installed and applied in a single unit on wearable devices, portable devices, handheld devices, and various kinds of electronic products or electronic components which need displays. Also, the display module may be applied as a matrix type to display devices such as monitors for personal computers (PCs), high resolution TVs and signage (or, digital signage), and electronic displays through a plurality of assembly arrangements.

The display module according to the disclosure may include a plurality of inorganic light emitting elements for displaying images arranged on a substrate wherein a thin film transistor is formed on one surface. The plurality of inorganic light emitting elements may be sub-pixels constituting a single pixel. In the disclosure, one `light emitting element,' one `micro LED,' and one 'sub-pixel' may be interchangeably used as the same meaning.

Hereinafter, embodiments will be described in detail with reference to the accompanying drawings, such that those having ordinary skill in the art to which the disclosure belongs can easily carry out the disclosure. However, it should be noted that the disclosure may be implemented in various different forms, and is not limited to the embodiments described herein. Also, in the drawings, parts that are not related to explanation were omitted, for explaining the disclosure clearly, and throughout the specification, similar components were designated by similar reference numerals.

Further, while embodiments will be described in detail with reference to the following accompanying drawings and the content described in the accompanying drawings, it is not intended that the disclosure is restricted or limited by the embodiments.

Hereinafter, a display device according to various embodiments will be described with reference to the drawings.

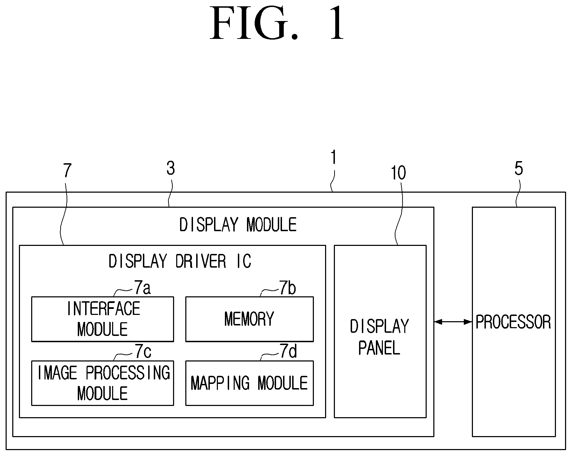

FIG. 1 is a block diagram illustrating a display device according to an embodiment.

Referring to FIG. 1, the display device 1 according to an embodiment may include a display module 3 and a processor 5.

The display module 3 may be a touch screen in which a touch sensor is combined with a display, such as a flexible display, a rollable display, and/or a 3D display. Also, according to an embodiment, the display module may be one of a plurality of display modules that are physically connected to implement a large-size display (e.g., a large format display (LFD)).

The display module 3 may display various images. Here, an image is a concept including a still image and/or a moving image. The display module 3 may display various images such as a broadcasting content, a multimedia content, etc. Also, the display module 3 may display a user interface and icons.

The display module 3 may include a display panel 10, and a display driver IC 7 for controlling the display panel 10.

The display driver IC 7 may include circuitry to implement an interface module 7a, a memory 7b (e.g.: a buffer memory), an image processing module 7c, or a mapping module 7d. The display driver IC 7 may, for example, receive image information including image data, or an image control signal corresponding to an instruction for controlling the image data from another component of the display device 1 through the interface module 7a. For example, according to an embodiment, the image information may be received from the processor 5 (e.g.: a main processor (e.g.: an application processor) or a subsidiary processor (e.g.: a graphic processing device) operated independently from the function of the main processor).

The display driver IC 7 may communicate with a sensor module through the interface module 7a. Also, the display driver IC 7 may store at least a portion of the received image information in the memory 7b, for example, in a frame unit. The image processing module 7c may, for example, perform pre-processing or post-processing (e.g.: adjustment of the resolution, the brightness, or the size) for the at least a portion of the image data at least based on the characteristic of the image data or the characteristic of the display panel 10. The mapping module 7d may generate a voltage value or a current value corresponding to the image data which went through pre-processing or post-processing through the image processing module 7c. According to an embodiment, generation of a voltage value or a current value may be performed at least based on the attributes of the pixels (e.g.: the arrangement of the pixels (an RGB stripe or a pentile structure), or the size of each sub-pixel) of the display panel 10. At least some pixels of the display panel 10 are driven, for example, at least based on the voltage value or the current value, and accordingly, visual information (e.g.: texts, images, or icons) corresponding to the image data may be displayed through the display panel 10.

The display driver IC 7 may transmit a driving signal (e.g.: a driver driving signal, a gate driving signal, etc.) to the display based on the image information received from the processor 5.

The display driver IC 7 may display an image based on an image signal received from the processor 5. As an example, the display driver IC 7 may display an image by generating a driving signal of a plurality of sub-pixels based on an image signal received from the processor 5, and controlling light emission of the plurality of sub-pixels based on the driving signal.

The display module 3 may further include a touch circuit. The touch circuit may include a touch sensor, and a touch sensor IC for controlling it. The touch sensor IC may, for example, control the touch sensor for detecting a touch input or a hovering input for a designated location of the display panel 10. For example, the touch sensor IC may detect a touch input or a hovering input by measuring change of a signal (e.g.: a voltage, a light amount, a resistance, or a charge amount) for a designated location of the display panel 10. The touch sensor IC may provide information regarding the detected touch input or hovering input (e.g.: the location, the area, the pressure, or the time) to the processor 5. According to an embodiment, at least a part (e.g.: the touch sensor IC) of the touch circuit may be included as a part of the display driver IC 7, or the display panel 10, or as a part of another component (e.g.: the subsidiary processor) arranged outside the display module 3.

The processor 5 may be implemented as a digital signal processor (DSP) processing digital image signals, a microprocessor, a graphics processing unit (GPU), an artificial intelligence (AI) processor, a neural processing unit (NPU), and a time controller (TCON). However, the disclosure is not limited thereto, and the processor 5 may include one or more of a central processing unit (CPU), a micro controller unit (MCU), a micro processing unit (MPU), a controller, an application processor (AP), or a communication processor (CP), and an ARM processor, or may be defined by the terms. Also, the processor 5 may be implemented as a system on chip (SoC) having a processing algorithm stored therein or large scale integration (LSI), or in the form of an application specific integrated circuit (ASIC), or a field programmable gate array (FPGA).

The processor 5 may operate the operating system or an application program, and thereby control hardware or software components connected to the processor 5, and perform various types of data processing and operations. Also, the processor 5 may load an instruction or data received from at least one of other components on a volatile memory and process them, and store various data in a non-volatile memory.

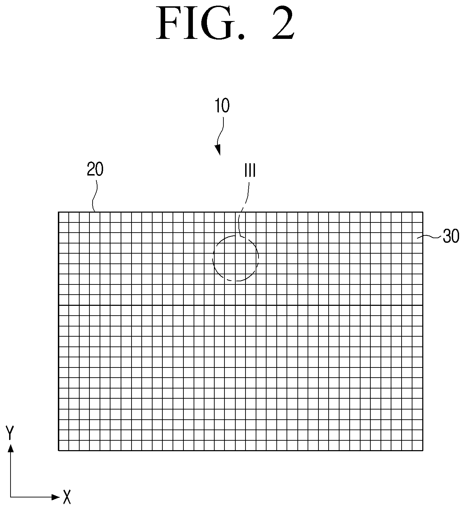

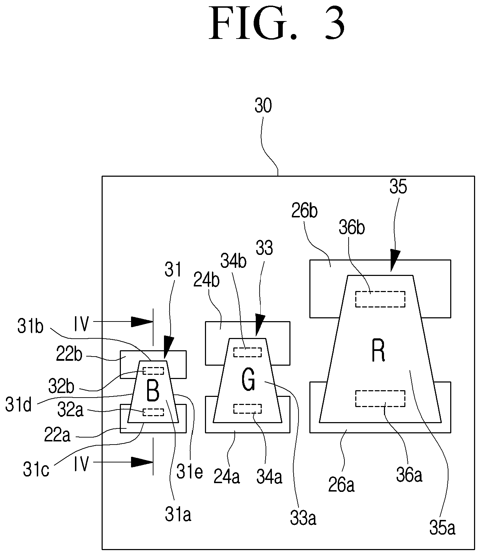

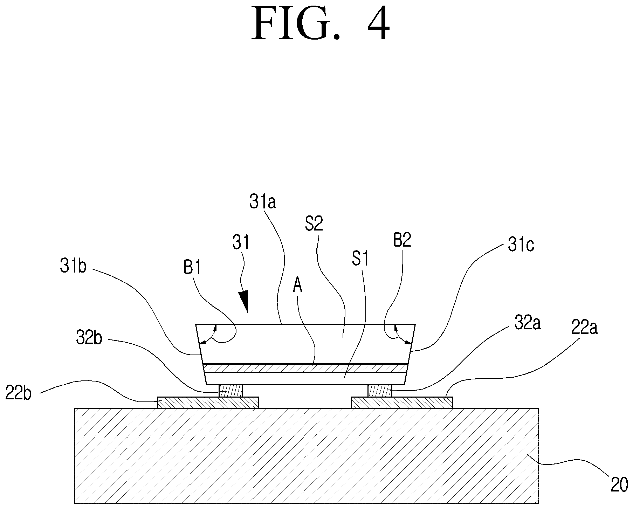

FIG. 2 is a plan view illustrating a display panel included in a display device according to an embodiment, FIG. 3 is a diagram illustrating pixels in the III portion indicated in FIG. 2 according to an embodiment, and FIG. 4 is a diagram illustrating a cross-sectional view of a first light emitting diode mounted on a TFT substrate according to an embodiment.

Referring to FIGS. 2 and 3, the display panel 10 may include a substrate, and a plurality of pixels arranged on the substrate.

The display panel 10 may include a substrate that can be implemented in forms such as an amorphous silicon (a-Si) TFT, a low temperature polycrystalline silicon (LTPS) TFT, a low temperature polycrystalline oxide (LTPO) TFT, a hybrid oxide and polycrystalline silicon (HOP) TFT, a liquid crystalline polymer (LCP) TFT, or an organic TFT (OTFT), etc.

The display panel 10 may include a plurality of pixel areas arranged in a matrix form. In each pixel area 30, one pixel may be arranged, and the one pixel may include a first light emitting diode 31 configured to emit a light of a blue wavelength band, a second light emitting diode 33 configured to emit a light of a green wavelength band, and a third light emitting diode 35 configured to emit a light of a red wavelength band.

In the one pixel area 30, in the area not occupied by the first light emitting diode 31, the second light emitting diode 33, and the third light emitting diode 35, a plurality of thin film transistors (TFTs) for driving the first to third light emitting diodes 31, 33, 35 may be arranged.

The first to third light emitting diodes 31, 33, 35 may be arranged in a row at specific intervals, but the disclosure is not limited thereto. For example, the first to third light emitting diodes 31, 33, 35 may be arranged in the shape of the character L, or arranged in a pentile RGBG method. The pentile RGBG method is a method of arranging the numbers of red, green, and blue light emitting diodes in a ratio of 1:1:2 (RGBG) by using the characteristic that humans can identify a green color the best, and cannot identify a blue color well. The pentile RGBG method is effective as it can improve the yield and reduce the unit cost, and implement a high resolution in a small screen.

The light emitting surfaces 31a, 33a, 35a of the first to third light emitting diodes 31, 33, 35 may be formed in approximate trapezoids. The size of the second light emitting diode 33 may be bigger than the size of the first light emitting diode 31. The size of the third light emitting diode 35 may be bigger than the size of the second light emitting diode 33.

A pair of electrodes 32a, 32b may be arranged on a surface opposite the light emitting surface 31a of the first light emitting diode 31. The pair of electrodes 32a, 32b may be physically and electrically connected to a pair of first electrode pads 22a, 22b arranged on one surface of the TFT substrate 20, respectively.

A pair of electrodes 34a, 34b may be arranged on a surface opposite the light emitting surface 33a of the second light emitting diode 33. The pair of electrodes 34a, 34b may be physically and electrically connected to a pair of second electrode pads 24a, 24b arranged on one surface of the TFT substrate 20, respectively.

As the size of the second light emitting diode 33 is bigger than the size of the first light emitting diode 31, the interval between the pair of electrodes 34a, 34b of the second light emitting diode 33 may be bigger than the interval between the pair of electrodes 32a, 32b of the first light emitting diode 31. Accordingly, the interval between the pair of second electrode pads 24a, 24b may be bigger than the interval between the pair of first electrode pads 22a, 22b. The sizes of the pair of second electrode pads 24a, 24b may be bigger than the sizes of the pair of first electrode pads 22a, 22b.

A pair of electrodes 36a, 36b may be arranged on a surface opposite the light emitting surface 35a of the third light emitting diode 35. The pair of electrodes 36a, 36b may be physically and electrically connected to a pair of third electrode pads 26a, 26b arranged on one surface of the TFT substrate 20, respectively.

As the size of the third light emitting diode 35 is bigger than the size of the second light emitting diode 33, the interval between the pair of electrodes 36a, 36b of the third light emitting diode 35 may be bigger than the interval between the pair of electrodes 34a, 34b of the second light emitting diode 33. Accordingly, the interval between the pair of third electrode pads 26a, 26b may be bigger than the interval between the pair of second electrode pads 24a, 24b. Also, the sizes of the pair of third electrode pads 26a, 26b may be bigger than the sizes of the pair of second electrode pads 24a, 24b.

The light emitting surfaces 3 1a, 33a, 35a of the first to third light emitting diodes 31, 33, 35 may be formed as planes, and they may be trapezoids of which left and right sides of the outermost parts are symmetrical. However, the shapes of the light emitting surfaces 31a, 33a, 35a of the first to third light emitting diodes 31, 33, 35 are not limited thereto, and they may be trapezoids of which left and right sides are asymmetrical.

The first to third light emitting diodes 31, 33, 35 may be micro light emitting diodes (LEDs) having a size of approximately 50 µm or smaller. The first to third light emitting diodes 31, 33, 35 may have a flip chip type structure wherein a pair of electrodes 32a, 32b, 34a, 34b, 36a, 36b are arranged on the opposite surfaces of the light emitting surfaces 31a, 33a, 33b. However, the disclosure is not limited thereto, and the first to third light emitting diodes 31, 33, 35 may be a lateral chip type, or a vertical chip type.

Although the sizes of the first to third light emitting diodes 31, 33, 35 are different, they consist of substantially the same structure. Thus, hereinafter, only the structure of the first light emitting diode 31 will be described with reference to the drawing.

Referring to FIG. 4, the first light emitting diode 31 may include a first semiconductor layer S1 and a second semiconductor layer S2 grown on an epitaxial substrate, and an active layer A arranged between the first semiconductor layer S1 and the second semiconductor layer S2.

The first semiconductor layer S1 may, for example, include a p-type semiconductor layer (an anode, an oxide electrode). The p-type semiconductor layer may, for example, be selected from GaN, AlN, AlGaN, InGaN, InN, InAlGaN, AlInN, etc., and may be doped using a p-type dopant such as Mg, Zn, Ca, Sr, Ba, etc.

The second semiconductor layer S2 may, for example, include an n-type semiconductor layer (a cathode, a reduction electrode). The n-type semiconductor layer may, for example, be selected from GaN, AIN, AlGaN, InGaN, InN, InAlGaN, AlInN, etc., and may be doped using an n-type dopant such as Si, Ge, Sn etc.

The epitaxially grown part of the first light emitting diode 31 is not limited to the aforementioned structure, and for example, the first semiconductor layer S1 may include an n-type semiconductor layer, and the second semiconductor layer S2 may include a p-type semiconductor layer. The active layer is an area wherein electrons and holes are recoupled, and as the electrons and the holes are recoupled, the active layer may be transitioned to a low energy level, and may emit a light having a wavelength corresponding thereto.

The active layer A may include a semiconductor material, for example, amorphous silicon or poly crystalline silicon. However, the disclosure is not limited thereto, and the active layer A may include an organic semiconductor material, etc., and may be formed of a single quantum well (SQW) structure or a multi quantum well (MQW) structure.

On the surface located on the opposite side of the light emitting surface 31a of the first light emitting diode 31, a pair of electrodes 32a, 32b may be arranged. If one electrode 32a is a positive electrode, the remaining electrode 32b may be a negative electrode. The pair of electrodes 32a, 32b may consist of an alloy including Ag or Au, but the disclosure is not limited thereto.

The first light emitting diode 31 may include a first side surface 31b, a second side surface 31c, a third side surface 31d, and a fourth side surface 31e between the light emitting surface 31 a and the opposite surface (referred to as 'the bottom surface' hereinafter) of the light emitting surface.

In case the size of the bottom surface of the first light emitting diode 31 is smaller than the size of the light emitting surface 31a, the first to fourth side surfaces 31b, 31c, 31d, 31e may be arranged to be inclined.

For example, the first and second side surfaces 31b, 31c of the first light emitting diode 31 may be arranged to be inclined from the upper side of the first light emitting diode 31 to the lower side as in FIG. 4. The first side surface 31b of the first light emitting diode 31 may be inclined by a first angle B1 with respect to the light emitting surface 31a, and the second side surface 31c of the first light emitting diode 31 may be inclined by a second angle B2 with respect to the light emitting surface 31a. In this case, both of the first angle B1 and the second angle B2 are acute angles, and they may be substantially identical angles. Accordingly, the cross-section of the first light emitting diode 31 may be an inverted trapezoid of which left and right sides are symmetrical. The third and fourth side surfaces 31d, 31e of the first light emitting diode 31 may constitute acute angles with respect to the light emitting surface 31a in a similar manner to the first and second side surfaces 31b, 31c.

The bottom surface of the first light emitting diode 31 is a plane, and it may be a rectangular form, but is not limited thereto. For example, the bottom surface of the first light emitting diode 31 may consist of various forms such as a square form or a trapezoid form. On the bottom surface of the first light emitting diode 31, a pair of electrodes 32a, 32b may be arranged at an interval.

The side surfaces of the second light emitting diode 33 and the side surfaces of the third light emitting diode 35 may be formed to be inclined in a similar manner to the side surfaces 31b, 31c, 31d, 31e of the first light emitting diode 31.

Hereinafter, a manufacturing method of a display device according to an embodiment will be described with reference to the drawings.

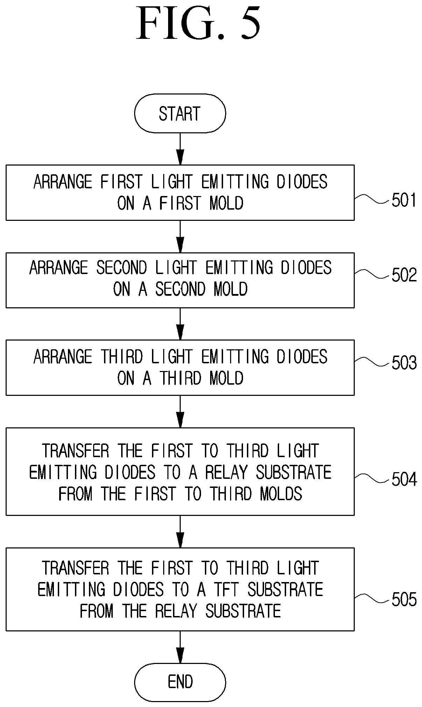

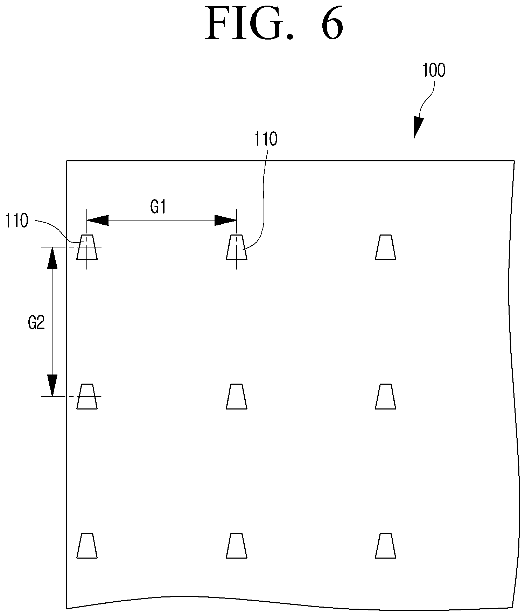

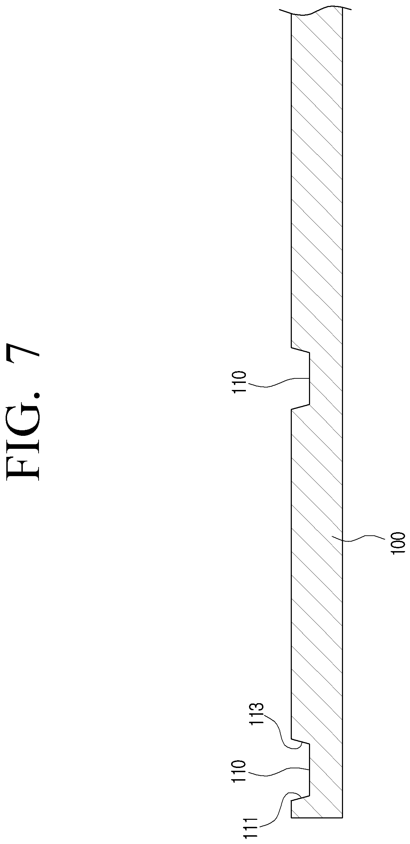

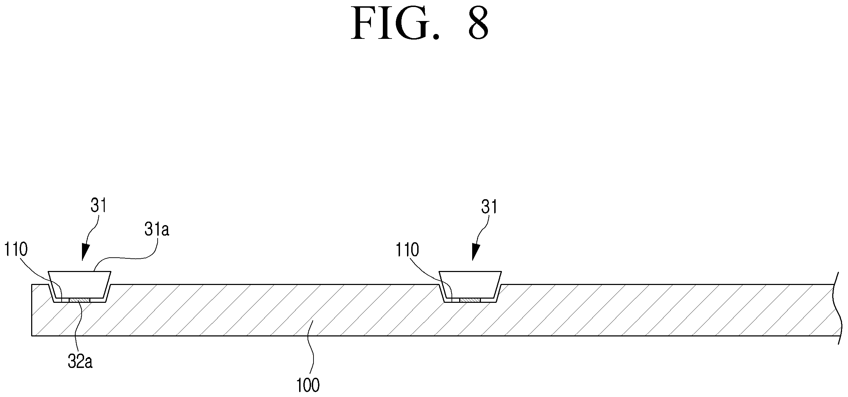

FIG. 5 is a flow chart illustrating a manufacturing method of a display device according to an embodiment, FIG. 6 is a plan view illustrating a first mold according to an embodiment, FIG. 7 is a cross-sectional view illustrating a first mold according to an embodiment, and FIG. 8 is a cross-sectional view illustrating first light emitting diodes inserted into insertion grooves of a first mold according to an embodiment.

The manufacturing method of a display device according to an embodiment may go through schematic processes as below. For example, a plurality of light emitting diodes may be respectively arranged on molds of each color (blue, green, red) by a fluidic self-assembly method. The plurality of light emitting diodes may be sequentially transported to a relay substrate from the molds of each color. The plurality of light emitting diodes in different colors arranged on the relay substrate may be transferred to the TFT substrate.

Hereinafter, the processes constituting the manufacturing method of a display device according to an embodiment will be described in detail.

In the disclosure, the plurality of first light emitting diodes 31 configured to emit a light of a blue wavelength may be arranged on the first mold 100 by a fluidic self-assembly method (501 in FIG. 5).

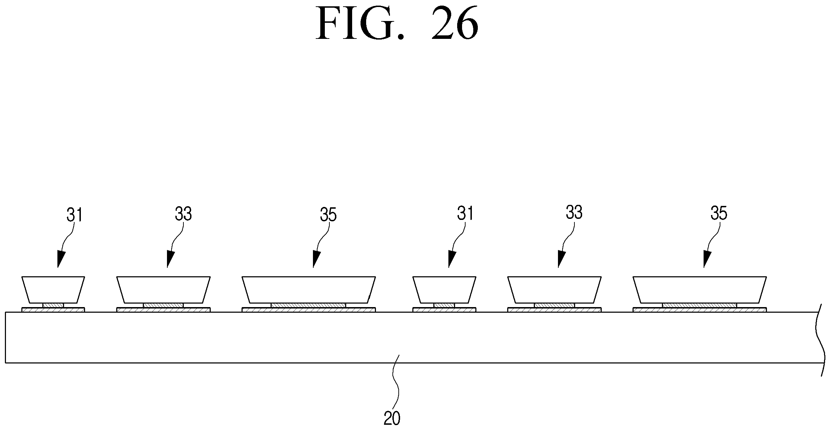

Referring to FIG. 6, on one surface of the first mold 100, a plurality of first insertion grooves 110 into which the first light emitting diodes 31 are respectively inserted may be formed. The plurality of first insertion grooves 110 may be arranged at a specific interval G1 in a row direction, and may be arranged at a specific interval G2 in a column direction. Such intervals G1, G2 may be in consideration of pitches among the pixels transferred to the TFT substrate 20 (refer to FIG. 26).

The opening of the first insertion groove 110 of the first mold 100 may have a shape approximately corresponding to the shape of the light emitting surface 31a of the first light emitting diode 31 when viewed from a plane. For example, the opening of the first insertion groove 110 of the first mold 100 may be a trapezoid.

The size of the opening of the first insertion groove 110 of the first mold 100 may be formed to be bigger than the size of the first light emitting diode 31, so that the first light emitting diode 31 can be easily inserted into the first insertion groove 110 of the first mold 100 in a fluidic self-assembly.

Referring to FIG. 7, the side surfaces 111, 113 of the first insertion groove 110 of the first mold 100 may be formed to be inclined. In this case, the width of the cross-section of the first insertion groove 110 of the first mold 100 may become gradually narrower as it approaches the bottom side from the opening side.

Referring to FIG. 8, as the shape of the first insertion groove 110 of the first mold 100 is formed to be similar to the shape of the first light emitting diode 31, the first light emitting diode 31 can be easily inserted into the first insertion groove 110 of the first mold 100 in a specific direction in a fluidic self-assembly.

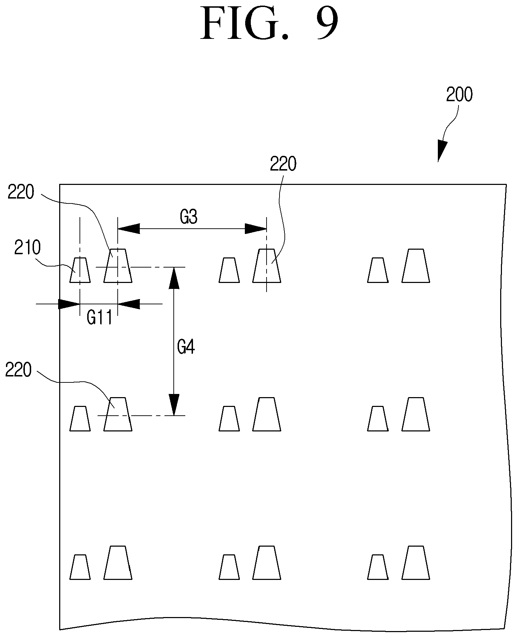

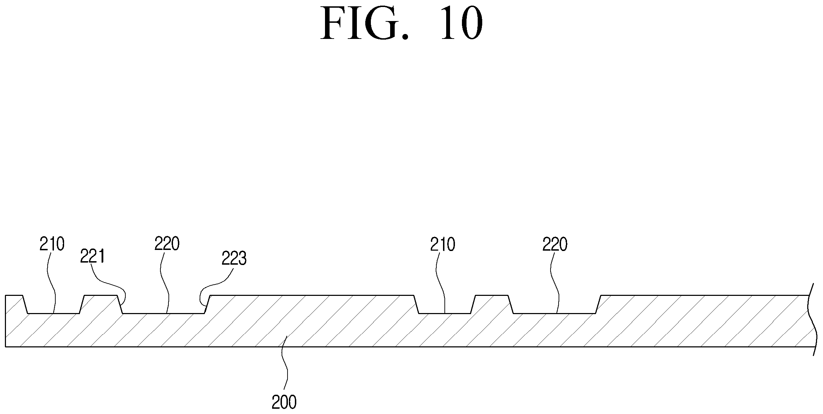

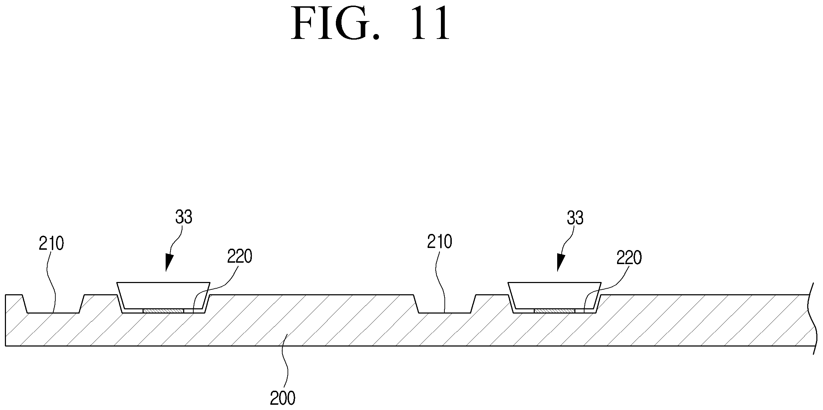

FIG. 9 is a plan view illustrating a second mold according to an embodiment, FIG. 10 is a cross-sectional view illustrating a second mold according to an embodiment, and FIG. 11 is a cross-sectional view illustrating second light emitting diodes inserted into insertion grooves of a second mold according to an embodiment.

In the disclosure, the plurality of second light emitting diodes 33 configured to emit a light of a green wavelength may be arranged on the second mold 200 by a fluidic self-assembly method (502 in FIG. 5).

Referring to FIG. 9, on one surface of the second mold 200, a plurality of second insertion grooves 220 into which the second light emitting diodes 33 are respectively inserted may be formed. The plurality of second insertion grooves 220 may be arranged at a specific interval G3 in a row direction, and may be arranged at a specific interval G4 in a column direction. Such intervals G3, G4 may be in consideration of pitches among the pixels transferred to the TFT substrate 20 (refer to FIG. 26).

The opening of the second insertion groove 220 of the second mold 200 may have a shape approximately corresponding to the shape of the light emitting surface 33a of the second light emitting diode 33 when viewed from a plane. For example, the opening of the second insertion groove 220 of the second mold 200 may be a trapezoid.

The size of the opening of the second insertion groove 220 of the second mold 200 may be formed to be bigger than the size of the second light emitting diode 33, so that the second light emitting diode 33 can be easily inserted into the second insertion groove 220 of the second mold 200 in a fluidic self-assembly.

Referring to FIG. 10, the side surfaces 221, 223 of the second insertion groove 220 of the second mold 200 may be formed to be inclined. In this case, the width of the cross-section of the second insertion groove 220 of the second mold 200 may become gradually narrower as it approaches the bottom side from the opening side.

Referring to FIG. 11, as the shape of the second insertion groove 220 of the second mold 200 is formed to be similar to the shape of the second light emitting diode 33, the second light emitting diode 33 can be easily inserted into the second insertion groove 220 of the second mold 200 in a specific direction in a fluidic self-assembly.

On the second mold 200, a plurality of first subsidiary insertion grooves 210 may be formed. The plurality of first subsidiary insertion grooves 210 may be respectively arranged at a specific interval G11 on the left side of the plurality of second insertion grooves 220. The plurality of first subsidiary insertion grooves 210 of the second mold 200 may be substantially identical to the shapes, the interval in the row direction, and the interval in the column direction of the plurality of first insertion grooves 110 of the first mold 100.

The plurality of second light emitting diodes 33 are inserted into the plurality of second insertion grooves 220 in a fluidic self-assembly, but the sizes of the second light emitting diodes 33 are bigger than the sizes of the plurality of first subsidiary insertion grooves 210, and thus the plurality of second light emitting diodes 33 are not inserted into the plurality of first subsidiary insertion grooves 210 of the second mold 200.

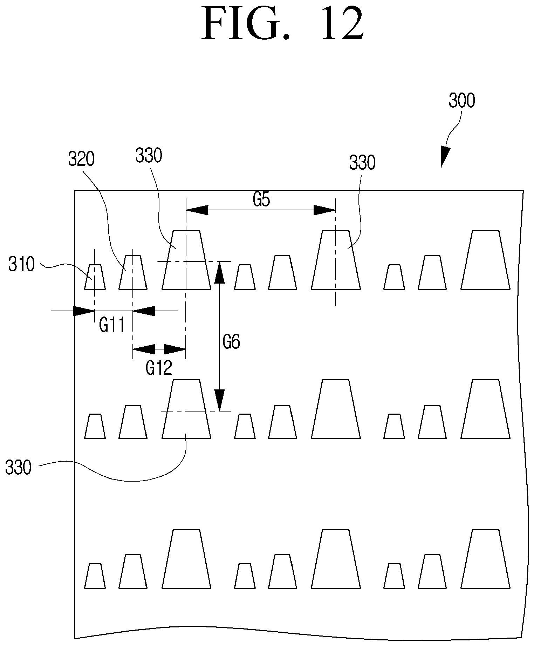

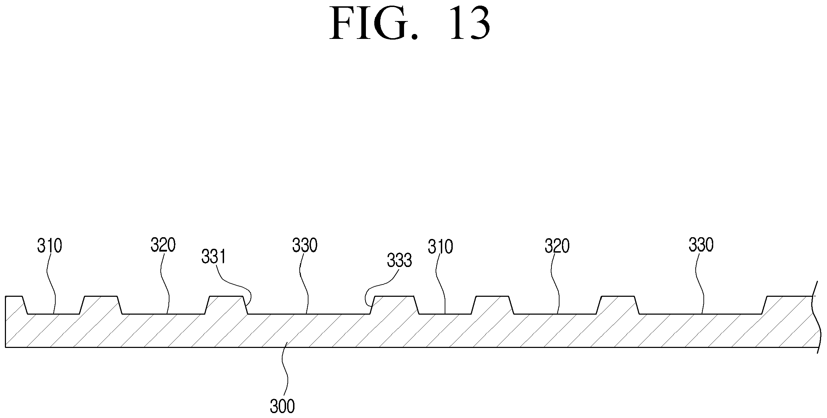

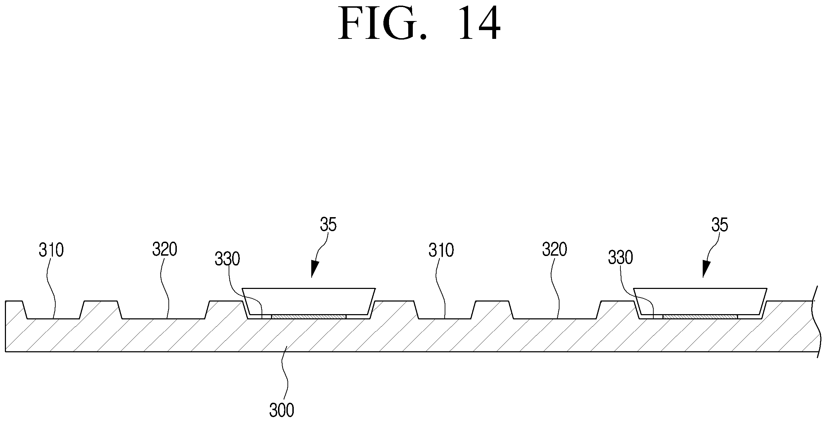

FIG. 12 is a plan view illustrating a third mold according to an embodiment, FIG. 13 is a cross-sectional view illustrating a third mold according to an embodiment, and FIG. 14 is a cross-sectional view illustrating third light emitting diodes inserted into insertion grooves of a third mold according to an embodiment.

In the disclosure, the plurality of third light emitting diodes 35 configured to emit a light of a red wavelength may be arranged on the third mold 300 by a fluidic self-assembly method (503 in FIG. 5).

Referring to FIG. 12, on one surface of the third mold 300, a plurality of third insertion grooves 330 into which the third light emitting diodes 35 are respectively inserted may be formed. The plurality of third insertion grooves 330 may be arranged at a specific interval G5 in a row direction, and may be arranged at a specific interval G6 in a column direction. Such intervals G5, G6 may be in consideration of pitches among the pixels transferred to the TFT substrate 20 (refer to FIG. 26).

The opening of the third insertion groove 330 of the third mold 300 may have a shape approximately corresponding to the shape of the light emitting surface 35a of the third light emitting diode 35 when viewed from a plane. For example, the opening of the third insertion groove 330 of the third mold 300 may be a trapezoid.

The size of the opening of the third insertion groove 330 of the third mold 300 may be formed to be bigger than the size of the third light emitting diode 35, so that the third light emitting diode 35 can be easily inserted into the third insertion groove 330 of the third mold 300 in a fluidic self-assembly.

Referring to FIG. 13, the side surfaces 331, 333 of the third insertion groove 330 of the third mold 300 may be formed to be inclined. In this case, the width of the cross-section of the third insertion groove 330 of the third mold 300 may become gradually narrower as it approaches the bottom side from the opening side.

Referring to FIG. 14, as the shape of the third insertion groove 330 of the third mold 300 is formed to be similar to the shape of the third light emitting diode 35, the third light emitting diode 35 can be easily inserted into the third insertion groove 330 of the third mold 300 in a specific direction in a fluidic self-assembly.

On the third mold 300, a plurality of second subsidiary insertion grooves 310 and a plurality of third subsidiary insertion grooves 320 may be formed. The plurality of third subsidiary insertion grooves 320 may be respectively arranged at a specific interval G12 on the left side of the plurality of third insertion grooves 330. The plurality of second subsidiary insertion grooves 310 may be respectively arranged at a specific interval G11 on the left side of the plurality of third subsidiary insertion grooves 320.

The plurality of second subsidiary insertion grooves 310 of the third mold 300 may be substantially identical to the shapes, the interval in the row direction, and the interval in the column direction of the plurality of first insertion grooves 110 of the first mold 100.

The plurality of third subsidiary insertion grooves 320 of the third mold 300 may be substantially identical to the shapes, the interval in the row direction, and the interval in the column direction of the plurality of second insertion grooves 220 of the second mold 200.

The plurality of third light emitting diodes 35 are inserted into the plurality of third insertion grooves 330 in a fluidic self-assembly, but the sizes of the third light emitting diodes 35 are bigger than the sizes of the plurality of second subsidiary insertion grooves 310 and the plurality of third subsidiary insertion grooves 320, and thus the plurality of third light emitting diodes 35 are not inserted into the plurality of second subsidiary insertion grooves 310 and the plurality of third subsidiary insertion grooves 320 of the third mold 300.

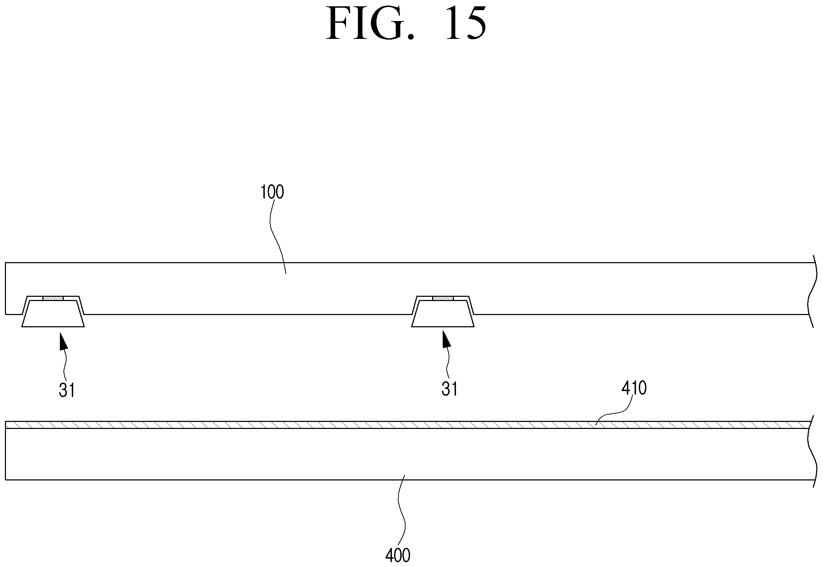

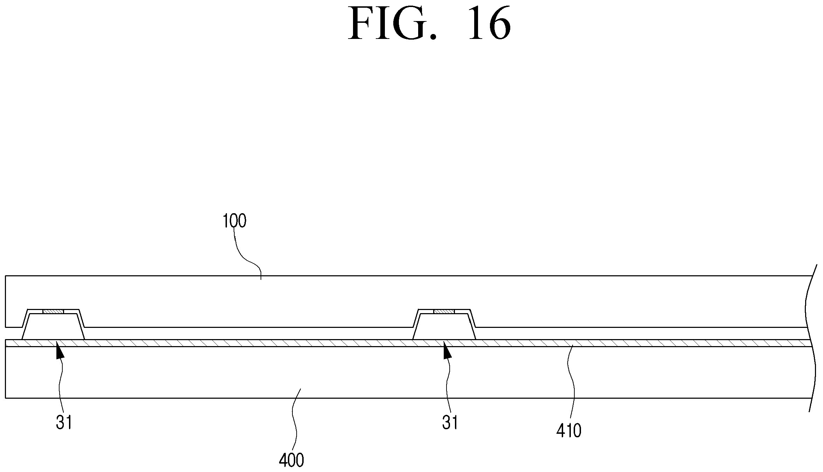

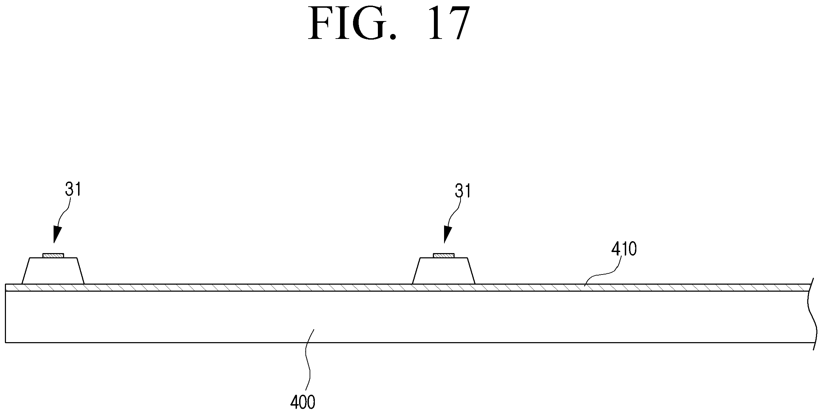

FIG. 15 is a diagram illustrating a first mold aligned on a relay substrate according to an embodiment, FIG. 16 is a diagram illustrating a first mold being provided to a relay substrate for transferring a plurality of first light emitting diodes to the relay substrate from the first mold according to an embodiment, and FIG. 17 is a diagram illustrating a plurality of first light emitting diodes that have been transferred to a relay substrate from a first mold according to an embodiment.

In the disclosure, the plurality of first light emitting diodes 31 arranged on the first mold 100, the plurality of second light emitting diodes 33 arranged on the second mold 200, and the plurality of third light emitting diodes 35 arranged on the third mold 300 may be sequentially transferred to the relay substrate 400 (504 in FIG 5).

Referring to FIG. 15, the first mold 100 may be arranged on the upper side of the relay substrate 400 at an interval and may be aligned with the relay substrate 400, for transferring the plurality of first light emitting diodes 31 to a predetermined location of the relay substrate 400. Here, the light emitting surfaces 31a of the plurality of first light emitting diodes 31 arranged on the first mold 100 may face the relay substrate 400.

On the plurality of first insertion grooves 110 of the first mold 100, an adhesion layer may be formed. Accordingly, the pair of electrodes 32a, 32b arranged on the bottom surfaces of the plurality of first light emitting diodes 31 inserted into the plurality of first insertion grooves 110 may be attached to the adhesion layer. When the plurality of first light emitting diodes 31 inserted into the plurality of first insertion grooves 110 are transferred to the relay substrate 400, the plurality of first light emitting diodes 31 may not be separated from the first mold 100 while they are being aligned with the relay substrate 400.

Referring to FIG. 16, the first mold 100 may be provided to one surface of the relay substrate 400 to bond the plurality of first light emitting diodes 31 to the relay substrate 400. In this case, the first mold 100 may be pressurized to the side of the relay substrate 400 by a specific pressure.

Accordingly, the light emitting surfaces 31a of the plurality of first light emitting diodes 31 arranged on the first mold 100 may be attached to an adhesion layer 410 formed on one surface of the relay substrate 400.

Referring to FIG. 17, the first mold 100 may be separated from the relay substrate 400.

The adhesion layer 410 of the relay substrate 400 may have a stronger adhesion force than the adhesion layer formed on the plurality of first insertion grooves 110 of the first mold 100. Accordingly, the plurality of first light emitting diodes 31 may be transferred to the relay substrate 400 from the first mold 100.

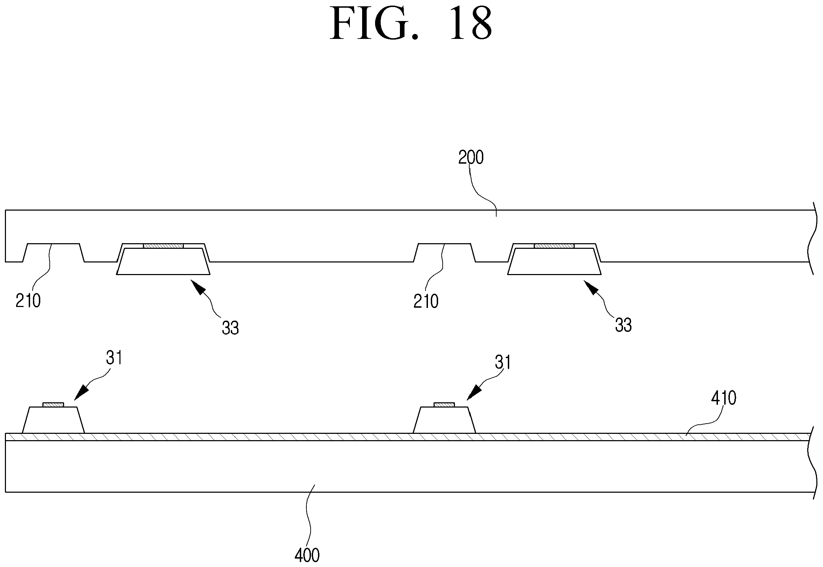

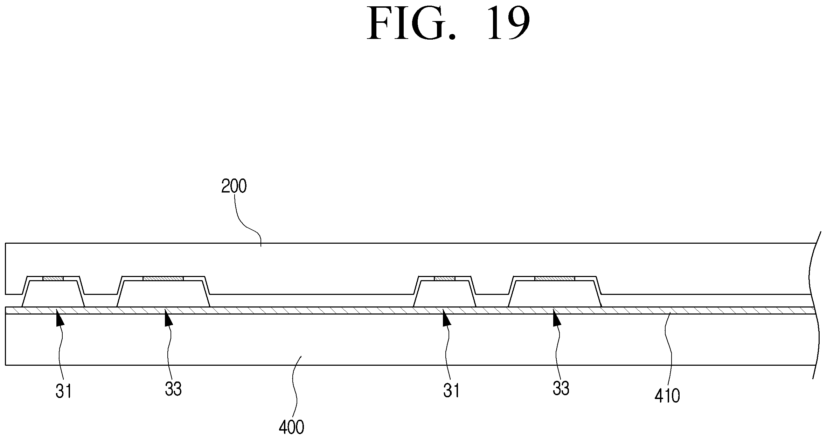

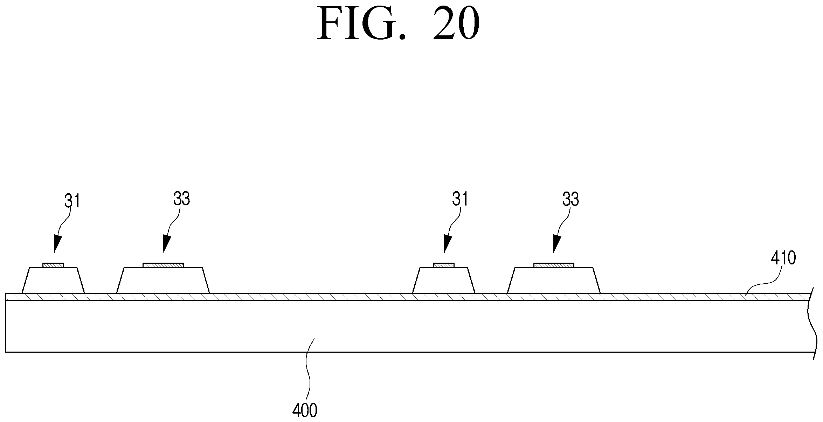

FIG. 18 is a diagram illustrating a second mold aligned on a relay substrate according to an embodiment, FIG. 19 is a diagram illustrating a second mold being provided to a relay substrate for transferring a plurality of second light emitting diodes to the relay substrate from the second mold according to an embodiment, and FIG. 20 is a diagram illustrating a plurality of second light emitting diodes that have been transferred to a relay substrate from a second mold according to an embodiment.

Referring to FIG. 18, the second mold 200 may be arranged on the upper side of the relay substrate 400 at an interval and may be aligned with the relay substrate 400, for transferring the plurality of second light emitting diodes 33 to a predetermined location of the relay substrate 400. Here, the light emitting surfaces 33a of the plurality of second light emitting diodes 33 arranged on the second mold 200 may face the relay substrate 400.

On the plurality of second insertion grooves 220 of the second mold 200, an adhesion layer may be formed. Accordingly, the pair of electrodes 34a, 34b arranged on the bottom surfaces of the plurality of second light emitting diodes 33 inserted into the plurality of second insertion grooves 220 may be attached to the adhesion layer. When the plurality of second light emitting diodes 33 inserted into the plurality of second insertion grooves 220 are transferred to the relay substrate 400, the plurality of second light emitting diodes 33 may not be separated from the second mold 200 while they are being aligned with the relay substrate 400.

Referring to FIG. 19, the second mold 200 may be provided to one surface of the relay substrate 400 to bond the plurality of second light emitting diodes 33 to the relay substrate 400.

The plurality of first light emitting diodes 31 transferred to the relay substrate 400 earlier may be inserted into the plurality of first subsidiary insertion grooves 210 of the second mold 200. Accordingly, when the plurality of second light emitting diodes 33 arranged on the second mold 200 are transferred to the relay substrate 400, the plurality of first light emitting diodes 31 transferred to the relay substrate 400 earlier may not interfere with the second mold 200.

The second mold 200 may be pressurized to the side of the relay substrate 400 by a specific pressure. Accordingly, the light emitting surfaces 33a of the plurality of second light emitting diodes 33 arranged on the second mold 200 may be attached to the adhesion layer 410 formed on one surface of the relay substrate 400.

Referring to FIG. 20, the second mold 200 may be separated from the relay substrate 400.

The adhesion layer 410 of the relay substrate 400 may have a stronger adhesion force than the adhesion layer formed on the plurality of second insertion grooves 220 of the second mold 200. Accordingly, the plurality of second light emitting diodes 33 may be transferred to the relay substrate 400 from the second mold 200.

Accordingly, on the relay substrate 400, the plurality of first light emitting diodes 31 and the plurality of second light emitting diodes 33 may be arranged in a grid form.

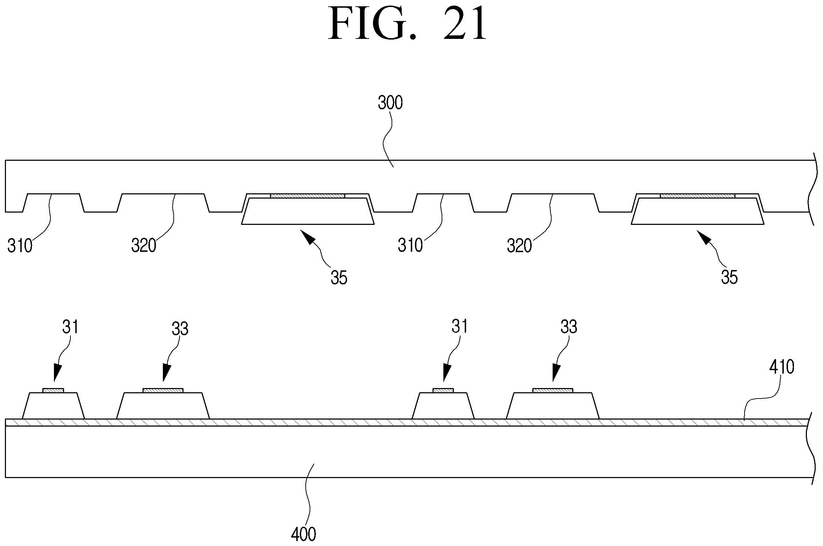

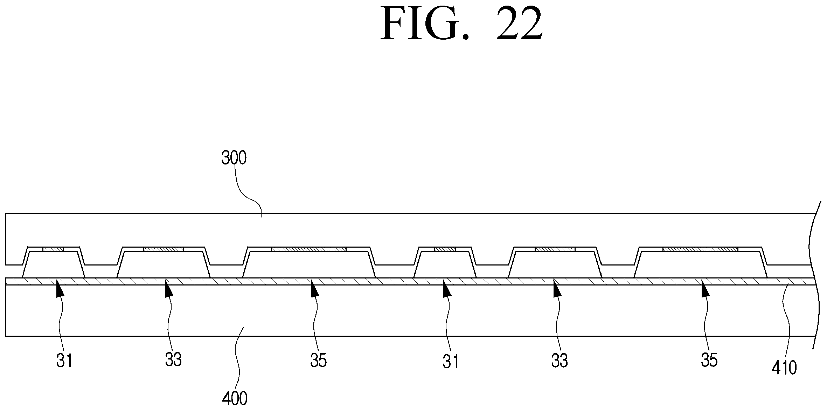

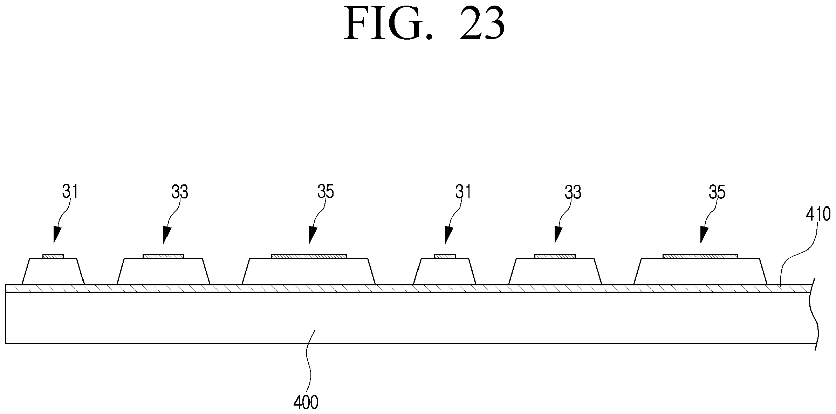

FIG. 21 is a diagram illustrating a third mold aligned on a relay substrate according to an embodiment, FIG. 22 is a diagram illustrating a third mold being provided to a relay substrate for transferring a plurality of third light emitting diodes to the relay substrate from the third mold according to an embodiment, and FIG. 23 is a diagram illustrating a plurality of third light emitting diodes that have been transferred to a relay substrate from a third mold according to an embodiment.

Referring to FIG. 21, the third mold 300 may be arranged on the upper side of the relay substrate 400 at an interval and may be aligned with the relay substrate 400, for transferring the plurality of third light emitting diodes 35 to a predetermined location of the relay substrate 400. Here, the light emitting surfaces 35a of the plurality of third light emitting diodes 35 arranged on the third mold 300 may face the relay substrate 400.

On the plurality of third insertion grooves 330 of the third mold 300, an adhesion layer may be formed. Accordingly, the pair of electrodes 36a, 36b arranged on the bottom surfaces of the plurality of third light emitting diodes 35 inserted into the plurality of third insertion grooves 330 may be attached to the adhesion layer. When the plurality of third light emitting diodes 35 inserted into the plurality of third insertion grooves 330 are transferred to the relay substrate 400, the plurality of third light emitting diodes 35 may not be separated from the third mold 300 while they are being aligned with the relay substrate 400.

Referring to FIG. 22, the third mold 300 may be provided to one surface of the relay substrate 400 to bond the plurality of third light emitting diodes 35 to the relay substrate 400.

The plurality of first light emitting diodes 31 transferred to the relay substrate 400 earlier may be inserted into the plurality of second subsidiary insertion grooves 310 of the third mold 300, and the plurality of second light emitting diodes 33 may be inserted into the plurality of third subsidiary insertion grooves 320 of the third mold 300. Accordingly, when the plurality of third light emitting diodes 35 arranged on the third mold 300 are transferred to the relay substrate 400, the plurality of first light emitting diodes 31 and the plurality of second light emitting diodes 33 transferred to the relay substrate 400 earlier may not interfere with the third mold 300.

The third mold 300 may be pressurized to the side of the relay substrate 400 by a specific pressure. Accordingly, the light emitting surfaces 35a of the plurality of third light emitting diodes 35 arranged on the third mold 300 may be attached to the adhesion layer 410 formed on one surface of the relay substrate 400.

Referring to FIG. 23, the third mold 300 may be separated from the relay substrate 400.

The adhesion layer 410 of the relay substrate 400 may have a stronger adhesion force than the adhesion layer formed on the plurality of third insertion grooves 330 of the third mold 300. Accordingly, the plurality of third light emitting diodes 35 may be transferred to the relay substrate 400 from the third mold 300.

Accordingly, on the relay substrate 400, the plurality of first light emitting diodes 31, the plurality of second light emitting diodes 33, and the plurality of third light emitting diodes 35 may be arranged in a grid form.

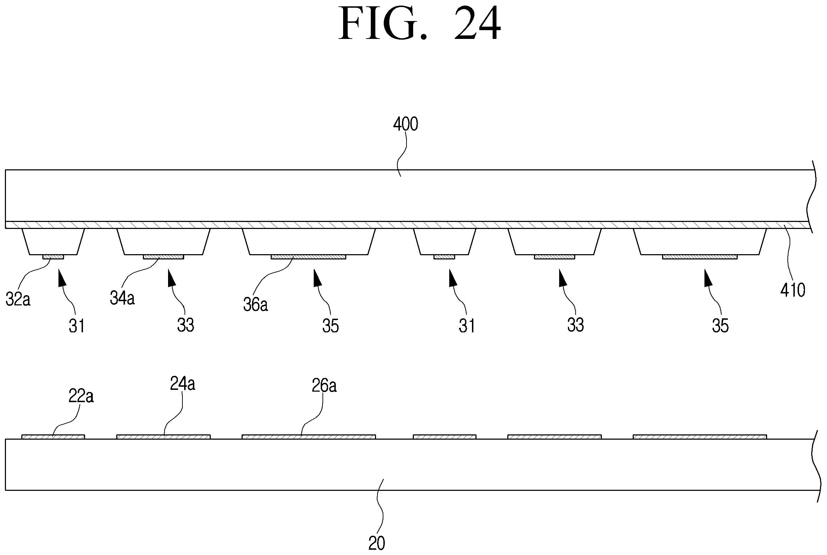

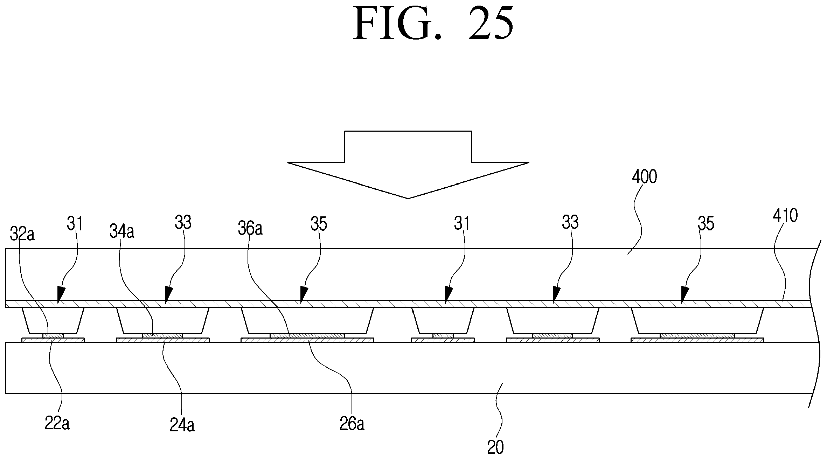

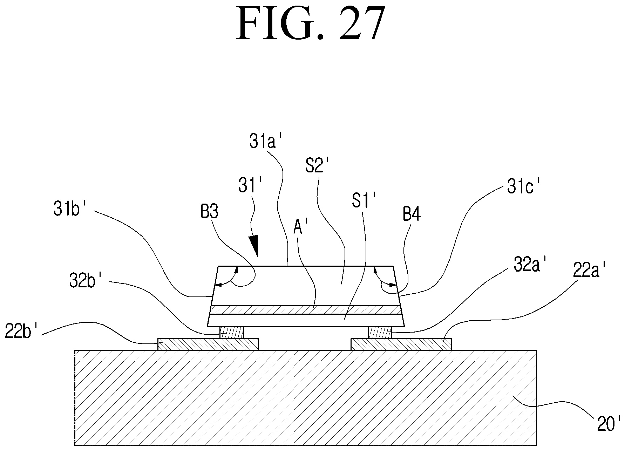

FIG. 24 is a diagram illustrating a relay substrate aligned on a TFT substrate according to an embodiment, FIG. 25 is a diagram illustrating a relay substrate being heat pressed to a TFT substrate according to an embodiment, FIG. 26 is a diagram illustrating a plurality of first to third light emitting diodes that have been transferred to a TFT substrate from a relay substrate according to an embodiment, and FIG. 27 is a cross-sectional view illustrating first light emitting diodes mounted on a TFT substrate according to an embodiment.

In the disclosure, the plurality of first light emitting diodes 31, the plurality of second light emitting diodes 33, and the plurality of third light emitting diodes 35 arranged on the relay substrate 400 may be transferred to the TFT substrate 20 (505 in FIG. 5).

Referring to FIG. 24, the relay substrate 400 may be arranged on the upper side of the TFT substrate 20 at an interval and may be aligned with the TFT substrate 20, for transferring the plurality of first to third light emitting diodes 31, 33, 35 to a predetermined location of the TFT substrate 20. Here, the light emitting surfaces 31a, 33a, 35a of the plurality of first to third light emitting diodes 31, 33, 35 arranged on the relay substrate 400 may face the TFT substrate 20.

On one surface of the TFT substrate 20 toward the relay substrate 400, electrode pads 22a, 22b, 24a, 24b, 26a, 26b corresponding to the electrodes 32a, 32b, 34a, 34b, 36a, 36b of the plurality of first to third light emitting diodes 31, 33, 35 may be arranged.

On one surface of the relay substrate 400, an adhesion layer (e.g., an anisotropic conductive film (ACF), an anisotropic conductive paste (ACP), a non-conductive film (NCF), a non-conductive paste (NCP), etc.) may be laminated so that the plurality of first to third light emitting diodes 31, 33, 35 can be mounted. In this case, the electrode pads 22a, 22b, 24a, 24b, 26a, 26b may be covered by the adhesion layer.

Referring to FIG. 25, the relay substrate 400 may be heat pressed to the TFT substrate 20 by a pressurizing member.

The electrodes 32a, 32b, 34a, 34b, 36a, 36b of the plurality of first to third light emitting diodes 31, 33, 35 may be bonded to the corresponding electrode pads 22a, 22b, 24a, 24b, 26a, 26b of the TFT substrate 20.

Referring to FIG. 26, the relay substrate 400 may be separated from the TFT substrate 20.

As the electrodes 32a, 32b, 34a, 34b, 36a, 36b of the plurality of first to third light emitting diodes 31, 33, 35 are bonded to the corresponding electrode pads 22a, 22b, 24a, 24b, 26a, 26b of the TFT substrate 20, the plurality of first to third light emitting diodes 31, 33, 35 can be easily separated from the relay substrate 400.

Through the process as above, the plurality of first to third light emitting diodes 31, 33, 35 may be transferred to the TFT substrate 20 from the relay substrate 400.

As described above, the cross-sections of the first to third light emitting diodes 31, 33, 35 transferred to the TFT substrate 20 may be inverted trapezoid forms, but the disclosure is not limited thereto. For example, the cross-sections of the first to third light emitting diodes 31, 33, 35 may be trapezoids. As described above, in case the cross-sections of the first to third light emitting diodes 31, 33, 35 are trapezoids, the process of using the relay substrate 400 may be omitted from the manufacturing method of the display module, and detailed explanation in this regard will be described below.

FIG. 27 is a cross-sectional view illustrating a first light emitting diode mounted on a TFT substrate according to an embodiment.

Referring to FIG. 27, the shape of the light emitting surface 31a' of the first light emitting diode 31' mounted on the TFT substrate 20' may be similar to the shape of the light emitting surface 31a of the first light emitting diode 31 described above. For example, the light emitting surface 31a' of the first light emitting diode 31' may be a trapezoid of which left and right sides are symmetrical, or a trapezoid of which left and right sides are asymmetrical.

In case the size of the light emitting surface 31a' of the first light emitting diode 31' being smaller than the size of the bottom surface, the four side surfaces of the first light emitting diode 31' may be arranged to be inclined.

For example, the first and second side surfaces 31b', 31c' of the first light emitting diode 31' may be arranged to be inclined from the upper side to the lower side of the first light emitting diode 31'. The first side surface 31b' of the first light emitting diode 31' may be inclined by a third angle B3 with respect to the light emitting surface 31a', and the second side surface 31c' of the first light emitting diode 31' may be inclined by a fourth angle B4 with respect to the light emitting surface 31a'. In this case, both of the third angle B3 and the fourth angle B4 are obtuse angles, and they may be substantially identical angles.

Also, the third and fourth side surfaces of the first light emitting diode 31' may constitute obtuse angles with respect to the light emitting surface 31a' in a similar manner to the first and second side surfaces 31b', 31c'.

The bottom surface of the first light emitting diode 31' is a plane, and it may be a rectangular form, but is not limited thereto. For example, the bottom surface of the first light emitting diode 31' may consist of various forms such as a square form or a trapezoid form.

The bottom surface of the first light emitting diode 31' may be wider than the light emitting surface 31a'. Accordingly, the cross-section of the first light emitting diode 31' may be a trapezoid.

On the bottom surface of the first light emitting diode 31', a pair of electrodes 32a', 32b' may be arranged at an interval. The pair of electrodes 32a', 32b' may be connected to a pair of first electrode pads 22a', 22b' of the TFT substrate 20', respectively.

The first light emitting diode 31' may include a first semiconductor layer S1' and a second semiconductor layer S2' grown on an epitaxial substrate, and an active layer A' arranged between the first semiconductor layer S1' and the second semiconductor layer S2'.

The structures of the second light emitting diode 33' and the third light emitting diode 35' may be constituted to be similar to the structure of the first light emitting diode 31'. The side surfaces of the second light emitting diode 33' and the side surfaces of the third light emitting diode 35' may be formed to be inclined in a similar manner to the side surfaces of the first light emitting diode 31' .

Hereinafter, a manufacturing method of a display device to which the first to third light emitting diodes 31', 33', 35' of which cross-sections are trapezoids are applied will be described.

The manufacturing method of a display device according to an embodiment may go through schematic processes as below. For example, a plurality of light emitting diodes may be respectively arranged on molds of each color (blue, green, red) by a fluidic self-assembly method. The plurality of light emitting diodes may be sequentially transported to a TFT substrate from the molds of each color. In this case, the process of using the relay substrate may be omitted.

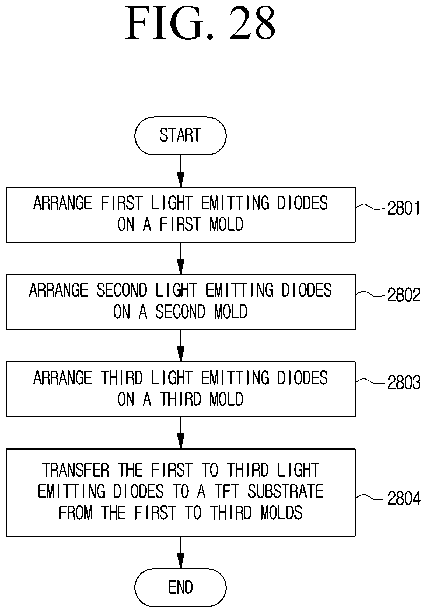

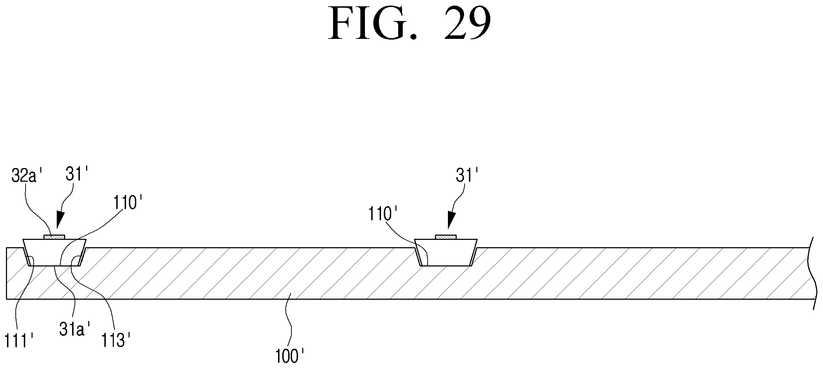

FIG. 28 is a flow chart illustrating a manufacturing method of a display device according to an embodiment, and FIG. 29 is a cross-sectional view illustrating an example wherein first light emitting diodes are inserted into insertion grooves of a first mold according to an embodiment.

In the disclosure, the plurality of first light emitting diodes 31 configured to emit a light of a blue wavelength may be arranged on the first mold 100 by a fluidic self-assembly method (2801 in FIG. 28).

Referring to FIG. 29, the structure of the first mold 100' may be a substantially identical structure to that of the first mold 100 (refer to FIGS. 6 and 7) described above. For example, the side surfaces 111', 113' of the first insertion groove 110' of the first mold 100' may be formed to be inclined. In this case, the width of the cross-section of the first insertion groove 110' of the first mold 100' may become gradually narrower as it approaches the bottom side from the opening side.

As the shape of the first insertion groove 110' of the first mold 100' is formed to be similar to the shape of the first light emitting diode 31', the first light emitting diode 31' can be easily inserted into the first insertion groove 110' of the first mold 100' in a specific direction in a fluidic self-assembly. In this case, the light emitting surface 31a' of the first light emitting diode 31' may be settled on the bottom of the first insertion groove 110' of the first mold 100'.

In the disclosure, the plurality of second light emitting diodes configured to emit a light of a green wavelength may be arranged on the second mold by a fluidic self-assembly method (2802 in FIG. 28).

In the disclosure, the plurality of third light emitting diodes configured to emit a light of a red wavelength may be arranged on the third mold by a fluidic self-assembly method (2803 in FIG. 28).

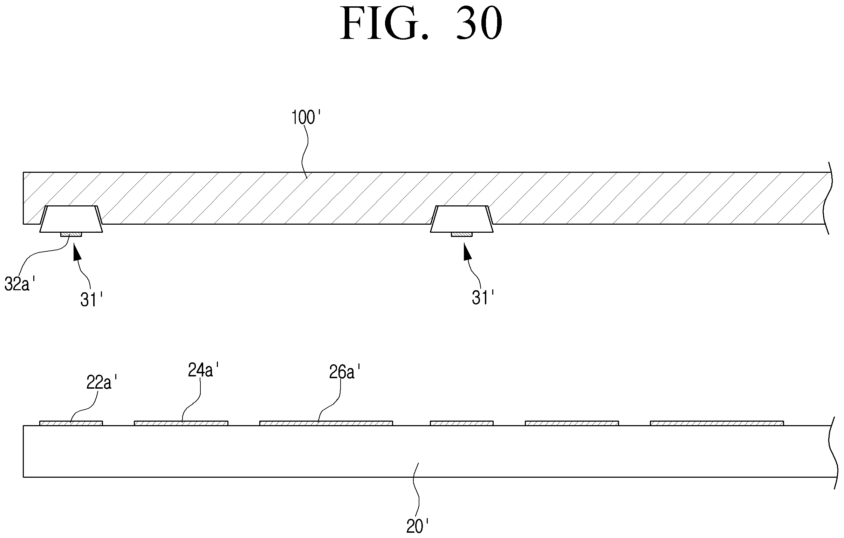

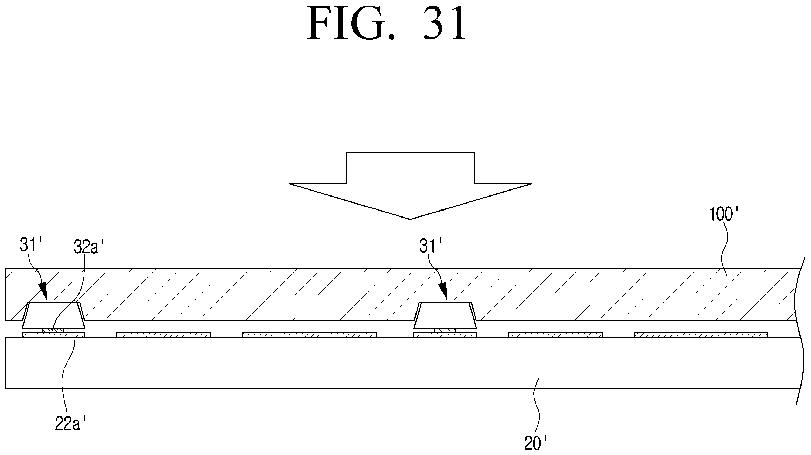

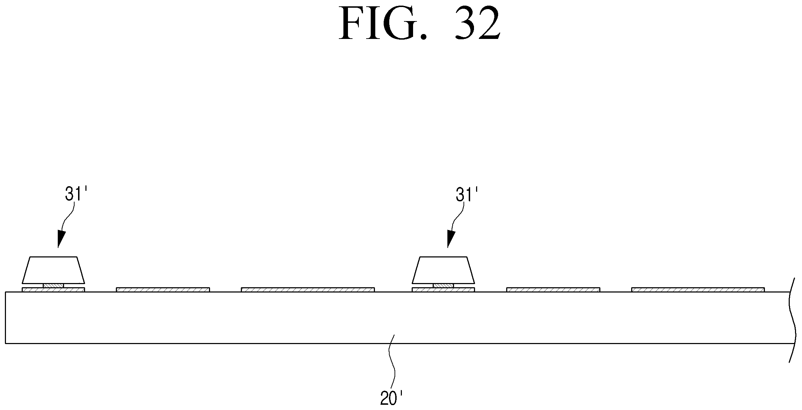

FIG. 30 is a diagram illustrating a first mold aligned on a TFT substrate according to an embodiment, FIG. 31 is a diagram illustrating a first mold being heat pressed to a TFT substrate according to an embodiment, and FIG. 32 is a diagram illustrating a plurality of first light emitting diodes that have been transferred to a TFT substrate from a first mold according to an embodiment.

In the disclosure, the plurality of first to third light emitting diodes 31', 33', 35' respectively arranged on the first to third molds are sequentially transferred to the TFT substrate 20' (2804 in FIG. 28).

Referring to FIG. 30, the first mold 100' may be arranged on the upper side of the TFT substrate 20' at an interval and may be aligned with the TFT substrate 20', for transferring the plurality of first light emitting diodes 31' to a predetermined location of the TFT substrate 20'. Here, the electrodes 32a' of the plurality of first light emitting diodes 31' arranged on the first mold 100' may face the TFT substrate 20'.

Referring to FIG. 31, the first mold 100' may be heat pressed to the TFT substrate 20' by a pressurizing member. Accordingly, the electrodes 32a' of the plurality of first light emitting diodes 31' may be respectively bonded to the corresponding electrode pads 22a' of the TFT substrate 20'. The electrodes of the first light emitting diodes 31' may include a pair of electrodes (an anode electrode and a cathode electrode).

Referring to FIG. 32, the first mold 100' may be separated from the TFT substrate 20'.

As the electrodes of the plurality of first light emitting diodes 31' are bonded to the corresponding electrode pads of the TFT substrate 20', the plurality of first light emitting diodes 31' may be separated from the first mold 100' easily.

Through a process as above, the plurality of first light emitting diodes 31' may be transferred to the TFT substrate 20' from the first mold 100'.

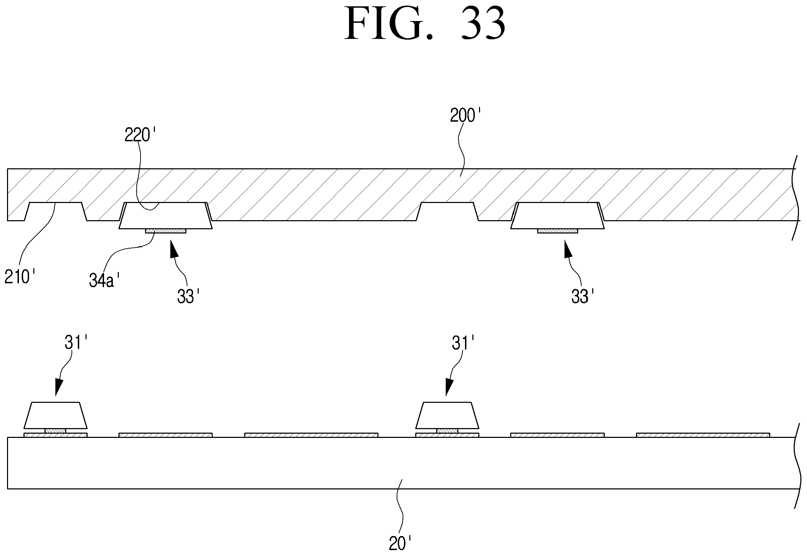

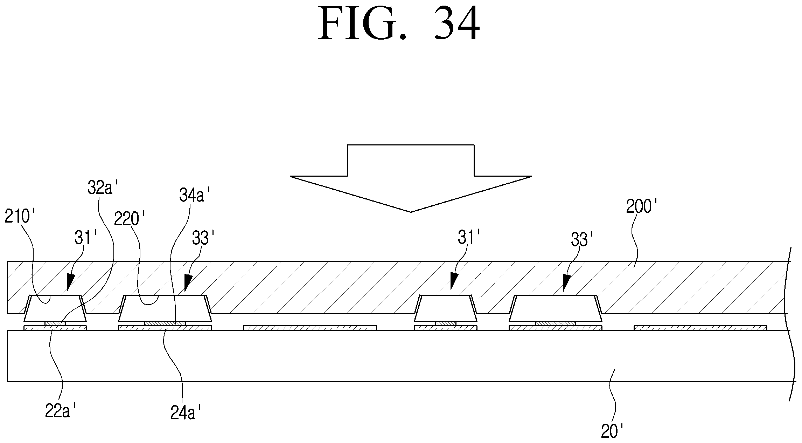

FIG. 33 is a diagram illustrating a second mold aligned on a TFT substrate according to an embodiment, and FIG. 34 is a diagram illustrating a second mold being heat pressed to a TFT substrate according to an embodiment.

Referring to FIG. 33, the second mold 200' may be arranged on the upper side of the TFT substrate 20' at an interval and may be aligned with the TFT substrate 20', for transferring the plurality of second light emitting diodes 33' to a predetermined location of the TFT substrate 20'. Here, the electrodes 34a' of the plurality of second light emitting diodes 33' arranged on the second mold 200' may face the TFT substrate 20'.

Referring to FIG. 34, the second mold 200' may be heat pressed to the TFT substrate 20' by a pressurizing member. The plurality of first light emitting diodes 31' transferred to the TFT substrate 20' earlier may be inserted into the plurality of first subsidiary insertion grooves 210' of the second mold 200'. Accordingly, when transferring the plurality of second light emitting diodes 33' arranged on the second mold 200' to the TFT substrate 20', the plurality of first light emitting diodes 31' transferred to the TFT substrate 20' earlier may not interfere with the second mold 200'.

By the heat pressing, the electrodes 34a' of the plurality of second light emitting diodes 33' may be respectively bonded to the corresponding electrode pads 24a' of the TFT substrate 20'. The electrodes of the second light emitting diodes 33' may include a pair of electrodes (an anode electrode and a cathode electrode).

After separating the second mold 200' from the TFT substrate 20', the plurality of third light emitting diodes 35' arranged on the third mold may be transferred to the TFT substrate 20'. Explanation regarding the process of transferring the plurality of third light emitting diodes 35' to the TFT substrate 20' from the third mold will be omitted.

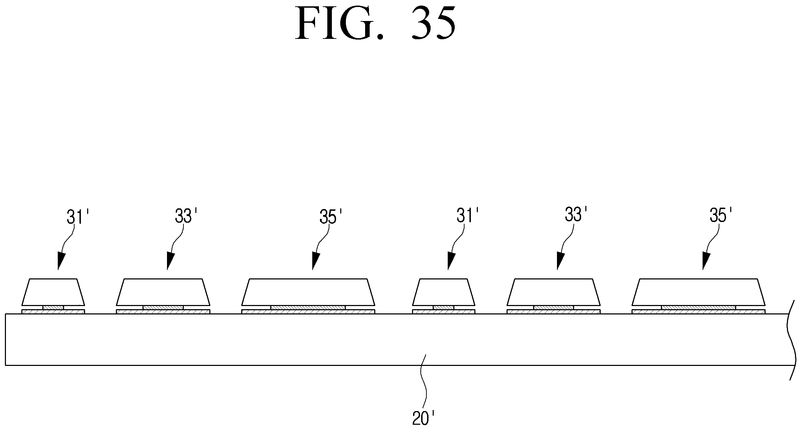

FIG. 35 is a diagram illustrating a plurality of third light emitting diodes that have been transferred to a TFT substrate from a third mold according to an embodiment.

Referring to FIG. 35, on the TFT substrate 20', the plurality of first to third light emitting diodes 31', 33', 35' sequentially transferred from the first mold 100', the second mold 200', and the third mold 300' may be arranged.

As described above, in the manufacturing method of a display module according to an embodiment, in case the first to third light emitting diodes 31', 33', 35' of which cross-sections are trapezoids are applied, the first to third light emitting diodes 31', 33', 35' may be transferred directly to the TFT substrate 20' from the first to third molds, without using an intermediate substrate.

While aspects of embodiments have been shown and described, the disclosure is not limited to the specifically described embodiments, and various modifications may be made by those having ordinary skill in the technical field to which the disclosure belongs, without departing from the gist of the disclosure as defined by the appended claims. Further, it is intended that such modifications are not to be interpreted independently from the technical idea or prospect of the disclosure.

## Claims

1. A display apparatus comprising:
a plurality of thin film transistors (TFTs) provided on a substrate; and
a plurality of pixels electrically connected to the plurality of TFTs,
wherein each pixel comprises a first light emitting diode, a second light emitting diode, and a third light emitting diode having different sizes from one another.

2. The display apparatus of claim 1, wherein the second light emitting diode is bigger than the first light emitting diode, and
wherein the third light emitting diode is bigger than the second light emitting diode.

3. The display apparatus of claim 2, wherein the first light emitting diode is configured to emit a light of a blue wavelength band,
wherein the second light emitting diode is configured to emit a light of a green wavelength band, and
wherein the third light emitting diode is configured to emit a light of a red wavelength band.

4. The display apparatus of claim 1, wherein a light emitting surface of each of the first light emitting diode, the second light emitting diode, and the third light emitting diode has a trapezoid shape.

5. The display apparatus of claim 4, wherein side surfaces of each of the first light emitting diode, the second light emitting diode, and the third light emitting diode are inclined.

6. The display apparatus of claim 5, wherein each of the first light emitting diode, the second light emitting diode, and the third light emitting diode has a cross-section that becomes gradually narrower as it approaches a surface opposite a light emitting surface.

7. The display apparatus of claim 5, wherein each of the first light emitting diode, the second light emitting diode, and the third light emitting diode has a cross-section that becomes gradually wider as it approaches a surface opposite a light emitting surface.

8. A mold device for manufacturing a display apparatus, comprising:
a first mold comprising a plurality of first insertion grooves arranged in a first grid, wherein the plurality of first insertion grooves have a first size into configured to accommodate a plurality of first light emitting diodes;
a second mold comprising a plurality of second insertion grooves arranged in a second grid, wherein the plurality of second insertion grooves have a second size bigger than the first size and are configured to accommodate a plurality of second light emitting diodes; and
a third mold wherein a plurality of third insertion grooves having a third size bigger than the second size into which a plurality of third light emitting diodes are inserted are arranged in a grid form,
wherein, in the second mold, a plurality of additional first insertion grooves corresponding to the first size are arranged in a grid form, and
wherein in the third mold, a plurality of additional second insertion grooves corresponding to the first size are arranged in a grid form, and a plurality of additional third insertion grooves corresponding to the second size are arranged in a grid form.

9. The mold device of claim 8, wherein the plurality of additional first insertion grooves of the second mold are arranged in locations corresponding to the plurality of first insertion grooves of the first mold,
wherein the plurality of additional second insertion grooves of the third mold are arranged in locations corresponding to the plurality of first insertion grooves of the first mold, and
wherein the plurality of additional third insertion grooves of the third mold are arranged in locations corresponding to the plurality of second insertion grooves of the second mold.

10. The mold device of claim 8, wherein the first size is bigger than the plurality of first light emitting diodes,
wherein the second size is bigger than the plurality of second light emitting diodes, and
wherein the third size is bigger than the plurality of third light emitting diodes.

11. The mold device of claim 8, wherein the plurality of first insertion grooves, the plurality of second insertion grooves, the plurality of third insertion grooves, the plurality of additional first insertion grooves, the plurality of additional second insertion grooves, and the plurality of additional third insertion grooves are trapezoid forms.

12. The mold device of claim 11, wherein side surfaces of each of the plurality of first insertion grooves, the plurality of second insertion grooves, and the plurality of third insertion grooves are inclined.

13. The mold device of claim 12, wherein a cross-section of each of the plurality of first insertion grooves, the plurality of second insertion grooves, and the plurality of third insertion grooves becomes gradually narrower as it approaches a bottom side from an opening side.

14. A method of manufacturing a display apparatus, the method comprising:
providing a plurality of first light emitting diodes in a first mold;
providing a plurality of second light emitting diodes in a second mold;
providing a plurality of third light emitting diodes in a third mold;
transferring the plurality of first light emitting diodes, the plurality of second light emitting diodes, and the plurality of third light emitting diodes to a relay substrate respectively from the first mold, the second mold, and the third mold; and
transferring the plurality of first light emitting diodes, the plurality of second light emitting diodes, and the plurality of third light emitting diodes to a thin film transistor (TFT) substrate from the relay substrate,
wherein the plurality of first light emitting diodes, the plurality of second light emitting diodes, and the plurality of third light emitting diodes are respectively inserted into a plurality of first insertion grooves of the first mold, a plurality of second insertion grooves of the second mold, and a plurality of third insertion grooves of the third mold by a fluidic self-assembly method.

15. The method of claim 14, wherein the plurality of first light emitting diodes, the plurality of second light emitting diodes, and the plurality of third light emitting diodes having different sizes from one another.
